# EUROPEAN PATENT APPLICATION

(11) **EP 1 722 602 A1**
(43) Date of publication of application: **15.11.2006**
(21) Application number: 05704043.8
(22) Date of filing: 24.01.2005
(51) Int. Cl.: H05B 33/14, H05B 33/22

(54) **ORGANIC ELECTROLUMINESCENT DEVICE AND ORGANIC ELECTROLUMINESCENT DISPLAY**

(30) Priority: 05.03.2004 JP 2004062772; 12.03.2004 JP 2004070075
(71) Applicant: IDEMITSU KOSAN CO., LTD., Tokyo 100-8321 (JP)
(72) Inventor: KAWAMURA, Hisayuki, Sodegaura-shi, Chiba 2990293 (JP); JUNKE, Tadanori, Sodegaura-shi, Chiba 2990293 (JP); FUKUOKA, Kenichi, Sodegaura-shi, Chiba 2990293 (JP)
(74) Representative: Gille, Christian
(86) International application number: PCT/JP2005/000862
(87) International publication number: WO 2005/086538

(57) **Abstract**

An organic electroluminescent device (1) including at least a cathode (3), an emitting layer (4), a hole-injecting layer (5) and an anode (6) on a substrate (2) in this order; the hole-injecting layer comprising a metal oxide: and an organic electroluminescent device including at least a cathode, an emitting layer, a metal oxide layer and an anode in this order on a substrate. As examples of the metal oxide, an oxide of a metal of the groups 3 to 13 in the long form periodic table can be given.

## Description

### Technical Field

The invention relates to an organic EL (electroluminescent) device and display, suitably employed in displays for personal and industrial uses, specifically a cell-phone, PDA, car-navigation, monitor, television and the like.

An organic EL display includes an organic EL device with an emitting layer held between opposing electrodes. When applying voltage between the electrodes of the device, electrons injected from one electrode and holes injected from the other electrode recombine in the emitting layer. The organic luminescent molecules in the emitting layer are excited by the recombination energy, and then return to the ground state from the excited state, releasing energy. The organic EL device emits light by converting this energy to light.

An organic EL device is formed on a substrate. An organic EL device is broadly classified into two types according to the direction of outcoupling light, that is, the top emission type in which light is outcoupled from the side opposite a substrate, and the bottom emission type in which light is outcoupled from the substrate side. When TFT is formed on a substrate, the top emission type is preferred since TFT interferes the outcoupling of light in the bottom emission type. In this case, an electrode through which light is outcoupled is required to be transparent. In organic EL devices, ITO is generally used as the transparent electrode. However ITO has a work function as large as 4.5 eV or more. This is significantly different from 4 eV or less which is a suitable work function for a cathode. Consequently an organic EL device is suggested where substrate/TFT/cathode/emitting layer/anode are stacked and ITO is used as the anode. The formation of an ITO film requires sputtering at a substrate temperature of 200°C or higher. Thus an emitting layer may be damaged or the layer structure of the organic EL device may change when an ITO film is formed as an anode, which leads to decrease in luminous efficiency, current leak, shortened lifetime and so on.

It is then suggested that a metal thin film is formed as a protecting film on a hole-injecting layer and a transparent anode is formed on the protecting film (for example, JP-A-H06-290873).

Combinations of a transparent electrode and various layers are also suggested. For example, JP-A-H08-185984 discloses the combination of a metal thin film and transparent electrode layer; JP-A-H10-162959 discloses the combination of a metal thin film and amorphous transparent electrode layer; JP-A-H10-294182 discloses the combination of a metal thin film, amorphous transparent electrode layer and metal; and JP-A-2000-048966 discloses the combination of a metal thin film and semiconductive thin film.

### Background Art

There still remain demands for other methods for extending the lifetime of an organic EL device by protecting an emitting layer.

An object of the invention is to provide an organic EL device and organic EL display with a high stability and long lifetime.

The inventors found through research that an organic EL device with a ling lifetime can be obtained by forming a layer containing a metal oxide, specifically a hole-injecting layer doped with a metal oxide, or a metal oxide layer for protecting an emitting layer in the region between an anode and emitting layer (hole injection/transport region), and completed the invention.

The invention provides the following organic EL device and organic EL display.
1. An organic electroluminescent device comprising: at least a cathode, an emitting layer, a hole-injecting layer and an anode on a substrate in this order; the hole-injecting layer comprising a metal oxide.
2. The organic electroluminescent device according to 1, wherein the hole-injecting layer has a thickness of 40 to 1000 nm.
3. The organic electroluminescent device according to 1 or 2, wherein the metal oxide is an oxide of a metal of the groups 3 to 13 in the long form periodic table.
4. The organic electroluminescent device according to any one of 1 to 3, wherein the metal oxide is one, or two or more metal oxides selected from a molybdenum oxide, vanadium oxide, hafnium oxide, yttrium oxide, zinc oxide and aluminum oxide.
5. The organic electroluminescent device according to any one of 1 to 4, wherein the hole-injecting layer comprises 0.01 to 50 atm% of the metal oxide.
6. The organic electroluminescent device according to any one of 1 to 5, wherein a protecting layer is provided between the hole-injecting layer and the anode.
7. The organic electroluminescent device according to 6, the protecting layer comprises a metal.
8. The organic electroluminescent device according to 6, wherein the protecting layer comprises Ag, Au or an alloy thereof.
9. The organic electroluminescent device according to 6, wherein the protecting layer comprises a semiconductor.
10. The organic electroluminescent device according to 6, wherein the protecting layer comprises an insulator.
11. The organic electroluminescent device according to any one of 1 to 10, wherein an insulative layer is provided between the cathode and the emitting layer.
12. The organic electroluminescent device according to any one of 1 to 11, wherein an electron-transporting layer is provided between the cathode and the emitting layer, or the insulative layer and the emitting layer.
13. An organic electroluminescent device comprising: at least a cathode, an emitting layer, a metal oxide layer and an anode on a substrate in this order.
14. The organic electroluminescent device according to 13, wherein the metal oxide layer comprises at least one metal oxide selected from a molybdenum oxide, vanadium oxide, rhenium oxide, ruthenium oxide, tungsten oxide, zinc oxide, titanium oxide and copper oxide.
15. The organic electroluminescent device according to 13 or 14, wherein the anode comprises a conductive film and a protecting film in this order from the substrate.
16. The organic electroluminescent device according to 15, wherein the protecting film comprises an oxide, a nitride or an oxynitride of at least one element selected from Si, Ge, Mg, Ta, Ti, Zn, Sn, In, Pb and Bi.
17. The organic electroluminescent device according to 15, wherein the protecting film comprises an oxide, a nitride or an oxynitride of at least one element selected from the group consisting of Mo, V, Cr, W, Ni, Co, Mn, Ir, Pt, Pd, Ce, Pr, Nd, Sm, Eu, Gd, Tb, Dy, Er and Yb.
18. The organic electroluminescent device according to any one of 15 to 17, wherein the protecting film transmits light.
19. The organic electroluminescent device according to any one of 15 to 18, wherein a metal layer is provided between the conductive film and the protecting film.
20. The organic electroluminescent device according to any one of 13 to 19, wherein a metal layer is provided between the metal oxide layer and the anode, or the emitting layer and the metal oxide layer.
21. The organic electroluminescent device according to 19 or 20, wherein the metal layer comprises an alloy containing at least one metal selected from Mg, Ag and Zr.
22. The organic electroluminescent device according to any one of 13 to 21, wherein the cathode comprises at least one metal selected from alkali metals and alkaline earth metal, and a metal oxide.
23 The organic electroluminescent device according to 22, wherein the metal oxide contained in the cathode is at least one metal oxide selected from LiₓTi₂O₄, LiₓV₂O₄, ErₓNbO₃, LaₓTiO₃, SrₓVO₃, CaₓCrO₃ and SrₓCrO₃ (X is 0.2 to 5).
24. The organic electroluminescent device according to 22, wherein the metal oxide contained in the cathode is at least one metal oxide selected from AₓMoO₃ (A is K, Cs, Rb, Sr, Na, Li or Ca) (x is 0.2 to 5) and AₓV₂O₅ (A is K, Cs, Rb, Sr, Na, Li or Ca) (x is 0.2 to 5).
25. The organic electroluminescent device according to any one of 1 to 24, wherein the anode is a transparent electrode and the cathode is a reflecting electrode.
26. A display comprising the organic electroluminescent device according to any one of 1 to 25.

According to the invention, a hole-injecting layer contains a metal oxide or a metal oxide layer is provided between an anode and an emitting layer, thereby providing an organic EL device and organic EL display with a high stability and long lifetime. In particular, even if the hole-injecting layer is thickened in order to protect the emitting layer, an increase in voltage caused by thickening the hole-injecting layer is prevented by the metal oxide.

### Brief Description of the Drawings

Fig. 1 is a view illustrating a first embodiment of the organic EL device according to the invention.
Fig. 2 is a view illustrating a second embodiment of the organic EL device according to the invention.

### Best Modes for Carrying Out the Invention

### [FIRST EMBODYMENT]

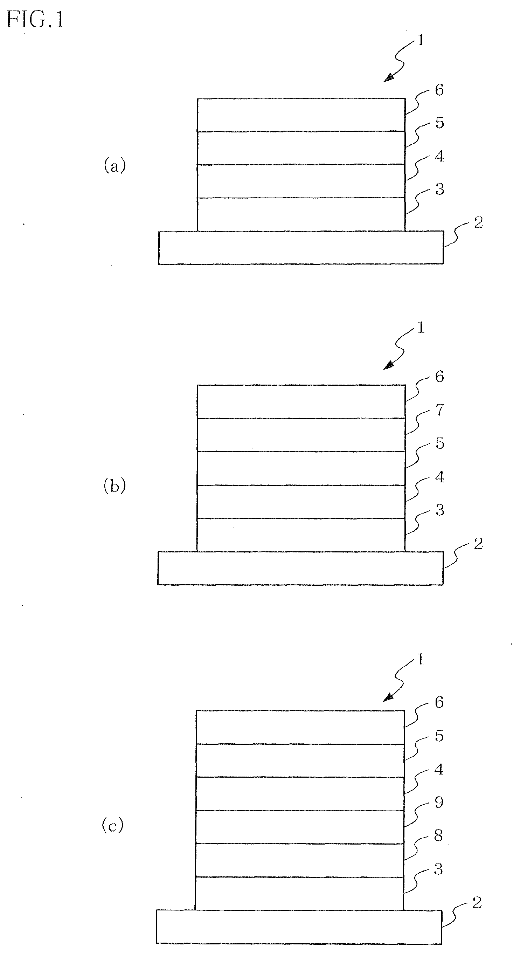

FIG. 1 is a view illustrating a first embodiment of the organic EL device of the invention.

The characteristic of this embodiment is that a hole-injecting layer contains a metal oxide. Although the hole-injecting layer is thickened, an increase in driving voltage can be controlled by containing a metal oxide.

In this embodiment, as shown in FIG. 1 (a), an organic EL device 1 comprises at least a cathode 3, an emitting layer 4, a hole-injecting layer 5 and an anode 6 on a substrate 2 in this order; and further comprises an interposing layer if necessary.

For example, FIG. 1 (b) shows that a protecting layer 7 may be provided between the hole-injecting layer 5 and the anode 6 so as to prevent sputtering damage to the hole-injecting layer when forming the anode. FIG. 1 (c) shows that an insulating layer 9 may also be provided between the cathode 3 and the emitting layer 4 so as to improve adhesion of the cathode and an organic compound, and prevent current leakage. In addition to the insulator layer 9, an electron-injecting layer 8 may be further provided so as to enhance the injection of electrons.

In the organic EL device of this embodiment, a metal oxide is added to a hole-injecting material mentioned later to form a hole-injecting layer. In the case where two or more hole-injecting layers are stacked, at least one of the hole-injecting layers may comprise a metal oxide.

The metal oxide is preferably an oxide of a metal of the groups 3 to 13 in the long form periodic table. There are preferred a molybdenum oxide, vanadium oxide, hafnium oxide, yttrium oxide, zinc oxide and aluminum oxide.

The addition amount of metal oxide relative to the hole-injecting layer is preferably 0.01 to 50 atm%, more preferably 0.05 to 30 atm%, even more preferably 0.1 to 10 atm%.

The film thickness of the hole-injecting layer is preferably 40 nm to 1000 nm, more preferably 60 nm to 300 nm, even more preferably 100 nm to 200 nm so as to prevent damage when forming the anode.

As methods of forming the hole-injecting layer comprising a metal oxide, known methods used for fabricating organic EL devices such as vacuum deposition, spin coating, sputtering and inkjet can be applied.

In the case where the hole-injecting layer is formed by vacuum deposition, molybdenum trioxide, vanadium pentoxide and the like are preferably used.

Members other than the metal oxide layer constituting the organic EL device of the embodiment will be described later.

For the first embodiment, the typical examples of the structure of the organic EL device other than FIG. 1 are shown below. The invention is not limited to these.
(i) Cathode/emitting layer/hole-injecting layer/protecting layer/anode
(ii) Cathode/emitting layer/hole-transporting layer/hole-injecting layer/protecting layer/anode
(iii)Cathode/electron-injecting layer/emitting layer/ hole-injecting layer/protecting layer/anode
(iv) Cathode/electron-injecting layer/emitting layer/hole-transporting layer/hole-injecting layer/protecting layer/anode
(v) Cathode/electron-injecting layer/electron-transporting layer/emitting layer/hole-injecting layer/protecting layer/anode
(vi) Cathode/electron-injecting layer/electron-transporting layer/emitting layer/hole-transporting layer/hole-injecting layer/protecting layer/anode

Among these, the structures (v) and (vi) are preferred.

### [SECOND EMBODYMENT]

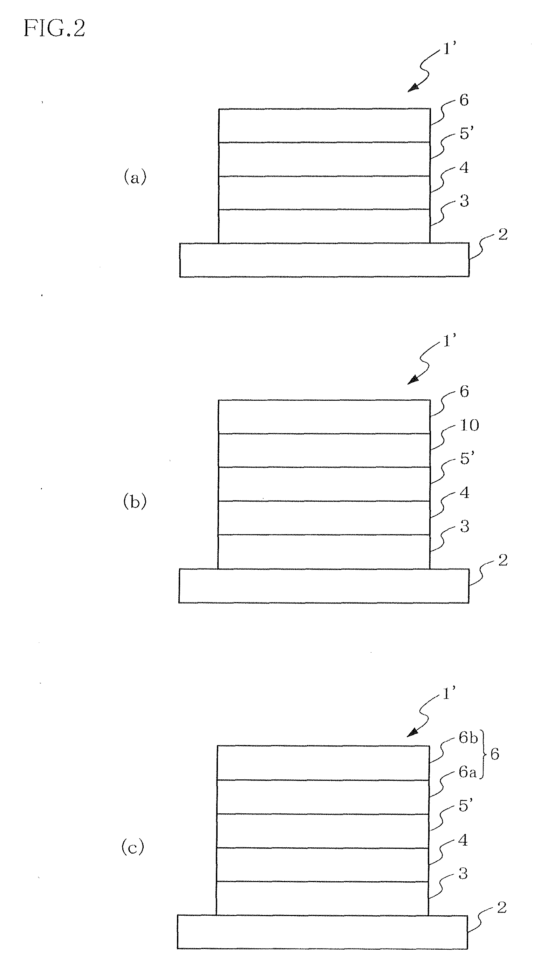

FIG. 2 is a view illustrating a second embodiment of the organic EL device of the invention.

The characteristic of this embodiment is that a metal oxide layer is formed between an anode and an emitting layer.

In this embodiment, as shown in FIG. 2 (a), an organic EL device 1' comprises at least a cathode 3, an emitting layer 4, a metal oxide layer 5' and an anode 6 on a substrate in this order. In this organic EL device 1, the anode 6 can be formed on the metal oxide layer 5' on the emitting layer 4 to prevent the emitting layer 4 from being damaged when forming the anode 6 by sputtering and the like.

An interposing layer can be provided if necessary in the organic EL device 1' of the invention. For example, as illustrated in FIG. 2(b), a metal layer 10 can be provided between the metal oxide layer 5' and the anode 6 so as to enhance luminous efficiency.

As illustrated in FIG. 2(c), the anode 6 can be made of a conductive film 6a and a protecting layer 6b, thereby preventing the organic EL device from being damaged by oxygen or moisture.

In this embodiment, the metal oxide forming the metal oxide layer is preferably an oxide of a metal of the groups 3 to 13 in the long form periodic table. Among these, there is preferred at least one metal oxide selected from molybdenum oxide, vanadium oxide, rhenium oxide, ruthenium oxide, tungsten oxide, zinc oxide, titanium oxide and copper oxide.

As methods of forming the metal oxide layer, known methods used for fabricating organic EL devices so as not to damage the emitting layer are preferred. Vacuum deposition, spin coating and inkjet are exemplified.

In the case of vacuum deposition, molybdenum trioxide are preferably used.

The film thickness is not particularly limited, but preferably 0.1 nm to 10 µm, and more preferably 1 nm to 1000 nm.

Members other than the metal oxide layer constituting the organic EL device of the embodiment will be described later.

For the second embodiment, the typical examples of the structure of the organic EL device other than FIG. 2 are shown below. The invention is not limited to these.
(i) Cathode/emitting layer/hole-injecting layer/metal oxide layer/anode
(ii) Cathode/emitting layer/hole-transporting layer/hole-injecting layer/metal oxide layer/anode
(iii)Cathode/electron-injecting layer/emitting layer/hole-injecting layer/metal oxide layer/anode
(iv) Cathode/electron-injecting layer/emitting layer/hole-transporting layer/hole-injecting layer/metal oxide layer/anode
(v) Cathode/electron-injecting layer/electron-transporting layer/emitting layer/hole-injecting layer/metal oxide layer/anode
(vi) Cathode/electron-injecting layer/electron-transporting layer/emitting layer/hole-transporting layer/hole-injecting layer/metal oxide layer/anode
(vii)Cathode/electron-injecting layer/electron-transporting layer/emitting layer/hole-transporting layer/hole-injecting layer/metal oxide layer/metal layer/anode
(viii) Cathode/electron-injecting layer/electron-transporting layer/emitting layer/hole-transporting layer/hole-injecting layer/metal layer/metal oxide layer/anode
(ix) Cathode/electron-injecting layer/electron-transporting layer/emitting layer/hole-transporting layer/hole-injecting layer/metal oxide layer/conductive layer/metal layer/ protecting layer

Among these, the structures (v) and (vi) are preferred.

In FIG. 1 and FIG. 2, the organic EL device may be top emission type wherein luminescence is outcoupled from the side opposite substrate 2, or bottom emission type wherein luminescence is outcoupled from the substrate 2. In the case where the organic EL device is of top emission type, the anode is a transparent electrode and the cathode is a reflecting electrode. In the case where the organic EL device is of bottom emission type, the anode is a reflecting electrode and the cathode is a transparent electrode.

Members included in the organic EL device of the first and second embodiments will be described below.

Members of the organic electroluminescent device of the above-mentioned embodiments 1 and 2 will be described below.

### (1) Substrate

The organic EL device of the invention is formed on a substrate.

A glass plate, polymer plate and the like are preferably used as a substrate. Soda-lime glass, barium/strontium-containing glass, lead glass, aluminosilicate glass, borosilicate glass, barium borosilicate glass, quartz and the like are preferred as a glass plate. Polycarbonate, acrylic polymer, polyethylene terephthalate, polyethersulfide, polysulfone and the like are preferred as a polymer plate.

### (2) Anode

It is preferable that the anode has a work function of 4.5 eV or more. As examples of the anode, indium tin oxide (ITO), indium zinc oxide (IZO), tin oxide (NESA), gold, silver, platinum, copper and the like can be given. Of these, indium zinc oxide (IZO) is particularly preferable, since IZO film can be formed at room temperature and is highly amorphous so that separation of the anode hardly occurs.

The sheet resistance of the anode is preferably 1000 Ω/□ or less, more preferably 800 Ω/□ or less, even more preferably 500 Ω /□ or less.

When luminescence is outcoupled from the anode, the transmittance of the anode to luminescence is preferably 10% or more, more preferably 30% or more, even more preferably 50% or more.

In the case where the anode is formed by stacking a conductive film and a protecting film, a material for the conductive film may be selected from the materials used for the anode. The protecting film is form of an oxide, a nitride or an oxynitride of at least one element selected from Si, Ge, Mg, Ta, Ti, Zn, Sn, In, Pb and Bi. Preferred is an oxide, a nitride or an oxynitride of at least one element selected from Mo, V, Cr, W, Ni, Co, Mn, Ir, Pt, Pd, Ce, Pr, Nd, Sm, Eu, Gd, Tb, Dy, Er and Yb.

In the case where luminescence from the emitting layer is outcoupled through the anode, the protecting film preferably has a transparency. Specifically, the transparency relative to luminescence is preferably more than 10%, more preferably 30% or more, even more preferably 50% or more.

Although the optimal value of the film thickness of the anode is dependent on the material thereof, the thickness is selected from 10 nm to 1 µm, preferably 10 nm to 200 nm.

A method for forming the anode is not particularly limited so long as the method is a known method, but there are preferred vacuum deposition, sputtering and application.

### (3) Emitting layer

As methods of forming the emitting layer, known methods such as vacuum deposition, spin coating and LB technique can be applied. As disclosed in JP-A-57-51781, an emitting layer can also be formed by dissolving a binder such as resins and material compound in a solvent to make a solution and forming a thin film therefrom by spin coating and so on.

The materials used in the emitting layer may be a material known as a luminescent material having a long lifetime. It is preferred to use, as the luminescent material, a material represented by a general formula (1). 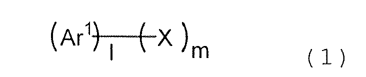 wherein Ar¹ is an aromatic ring with 6 to 50 nucleus carbon atoms, X is a substituent, 1 is an integer of 1 to 5, and m is an integer of 0 to 6.

Specific examples of the aromatic ring Ar¹ include phenyl, naphthyl, anthracene, biphenylene, azulene, acenaphthylene, fluorene, phenanthrene, fluoranthene, acephenanthrylene, triphenylene, pyrene, chrysene, naphthacene, picene, perylene, penthaphene, pentacene, tetraphenylene, hexaphene, hexacene, rubicene, coronene, and trinaphthylene rings.

Preferred examples thereof include phenyl, naphthyl, anthracene, acenaphthylene, fluorene, phenanthrene, fluoranthene, triphenylene, pyrene, chrysene, perylene, and trinaphthylene rings.

More preferred examples thereof include phenyl, naphthyl, anthracene, fluorene, phenanthrene, fluoranthene, pyrene, chrysene, and perylene rings.

Specific examples of X include substituted or unsubstituted aromatic groups with 6 to 50 nucleus carbon atoms, substituted or unsubstituted aromatic heterocyclic groups with 5 to 50 nucleus carbon atoms, substituted or unsubstituted alkyl groups with 1 to 50 carbon atoms, substituted or unsubstituted alkoxy groups with 1 to 50 carbon atoms, substituted or unsubstituted aralkyl groups with 1 to 50 carbon atoms, substituted or unsubstituted aryloxy groups with 5 to 50 nucleus atoms, substituted or unsubstituted arylthio groups with 5 to 50 nucleus atoms, substituted or unsubstituted carboxyl groups with 1 to 50 carbon atoms, substituted or unsubstituted styryl groups, halogen groups, a cyano group, a nitro group, and a hydroxyl group.

Examples of the substituted or unsubstituted aromatic groups with 6 to 50 nucleus carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-fluorenyl, 9,9-dimethyl-2-fluorenyl and 3-fluorantenyl groups.

Preferred examples thereof include phenyl, 1-naphthyl, 2-naphthyl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, o-tolyl, m-tolyl, p-tolyl, p-t-butylphenyl, 2-fluorenyl, 9,9-dimethyl-2-fluorenyl and 3-fluorantenyl groups.

Examples of the substituted or unsubstituted aromatic heterocyclic groups with 5 to 50 nucleus carbon atoms include 1-pyrrolyl, 2-pyrrolyl, 3-pyrrolyl, pyrazinyl, 2-pyridinyl, 3-pyridinyl, 4-pyridinyl, 1-indolyl, 2-indolyl, 3-indolyl, 4-indolyl, 5-indolyl, 6-indolyl, 7-indolyl, 1-isoindolyl, 2-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 9-carbazolyl, 1-phenanthrydinyl, 2-phenanthrydinyl, 3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 10-phenothiazinyl, 1-phenoxazinyl, 2-phenoxazinyl, 3-phenoxazinyl, 4-phenoxazinyl, 10-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl 1-indolyl, 4-t-butyl 1-indolyl, 2-t-butyl 3-indolyl, and 4-t-butyl 3-indolyl groups.

Examples of the substituted or unsubstituted alkyl groups with 1 to 50 carbon atoms include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, 1,2,3-trinitropropyl, cyclopropyl, cyclobutyl, cyclopentyl, cyclohexyl, 4-methylcyclohexyl, 1-adamanthyl, 2-adamanthyl, 1-norbornyl, and 2-norbornyl groups.

The substituted or unsubstituted alkoxy groups with 1 to 50 carbon atoms are groups represented by -OY. Examples of Y include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihyroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, and 1,2,3-trinitropropyl groups.

Examples of the substituted or unsubstituted aralkyl groups with 1 to 50 carbon atoms include benzyl, 1-phenylethyl, 2-phenylethyl, 1-phenylisopropyl, 2-phenylisopropyl, phenyl-t-butyl, α-naphthylmethyl, 1-α-naphthylethyl, 2-α-naphthylethyl, 1-α-naphthylisopropyl, 2-α-naphthylisopropyl, β-naphthylmethyl, 1-β-naphthylethyl, 2-β-naphthylethyl, 1-β-naphthylisopropyl, 2-β-naphthylisopropyl, 1-pyrrolylmethyl, 2-(1-pyrrolyl)ethyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, 1-hydroxy-2-phenylisopropyl, and 1-chloro-2-phenylisopropyl groups.

The substituted or unsubstituted aryloxy groups with 5 to 50 nucleus atoms are represented by -OY'. Examples of Y' include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-pyrrolyl, 3-pyrrolyl, pyrazinyl, 2-pyridinyl, 3-pyridinyl, 4-pyridinyl, 2-indolyl, 3-indolyl, 4-indolyl, 5-indolyl, 6-indolyl, 7-indolyl, 1-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 1-phenanthrydinyl, 2-phenanthrydinyl, 3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 1-phenoxazinyl, 2-phenoxazinyl, 3-phenoxazinyl, 4-phenoxazinyl, 2-oxazolyl, 4-oxazolyl, 5-oxazolyl, 2-oxadiazolyl, 5-oxadiazolyl, 3- furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl 1-indolyl, 4-t-butyl 1-indolyl, 2-t-butyl 3-indolyl, and 4-t-butyl 3-indolyl groups.

The substituted or unsubstituted arylthio groups with 5 to 50 nucleus atoms are represented by -SY", and examples of Y" include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-pyrrolyl, 3-pyrrolyl, pyrazinyl, 2-pyridinyl, 3-pyridinyl, 4-pyridinyl, 2-indolyl, 3-indolyl, 4-indolyl, 5-indolyl, 6-indolyl, 7-indolyl, 1-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 1-phenanthrydinyl, 2-phenanthrydinyl, 3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 1-phenoxazinyl, 2-phenoxazinyl, 3-phenoxazinyl, 4-phenoxazinyl, 2-oxazolyl, 4-oxazolyl, 5-oxazolyl, 2-oxadiazolyl, 5-oxadiazolyl, 3- furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl 1-indolyl, 4-t-butyl 1-indolyl, 2-t-butyl 3-indolyl, and 4-t-butyl 3-indolyl groups.

The substituted or unsubstituted carboxyl groups with 1 to 50 carbon atoms are represented by -COOZ, and examples of Z include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihyroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, and 1,2,3-trinitropropyl groups.

Examples of the substituted or unsubstituted styryl groups include 2-phenyl-1-vinyl, 2,2-diphenyl-1-vinyl, and 1,2,2-triphenyl-1-vinyl groups.

Examples of the halogen groups include fluorine, chlorine, bromine and iodine.

1 is an integer of 1 to 5, preferably 1 to 2. m is an integer of 0 to 6, preferably 0 to 4.

Ar¹s may be the same as or different from each other when 1 is 2 or more, and Xs may be the same as or different from each other when m is 2 or more.

Specific examples of the compounds represented by the formula (1) are illustrated below.

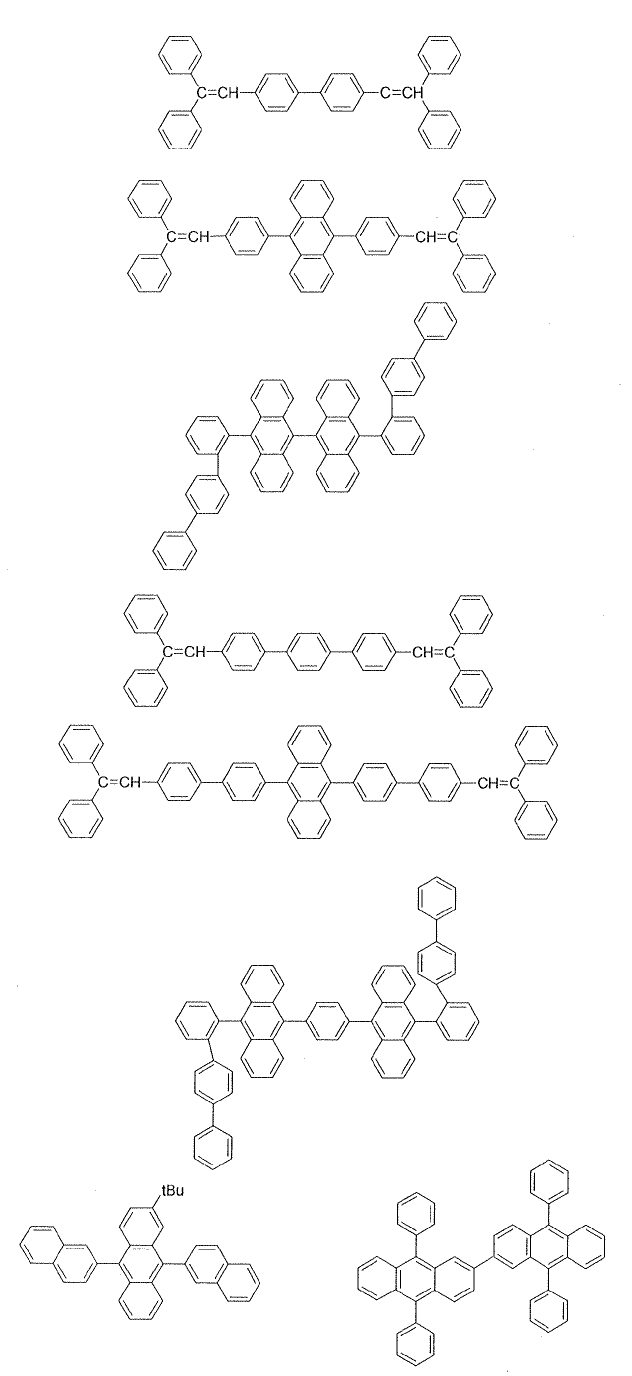

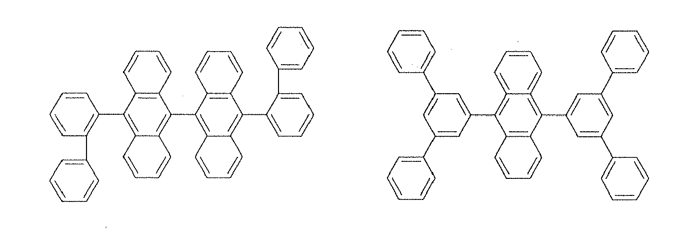

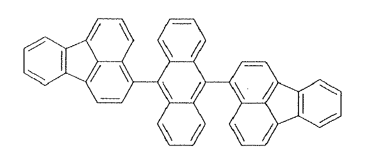

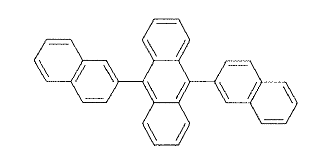

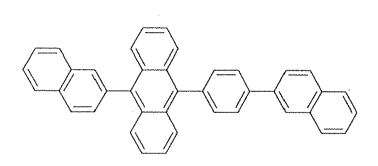

In the emitting layer, its emission capability can be improved by adding a fluorescent compound as a dopant. Dopants known as a dopant material having a long lifetime may be used. It is preferred to use, as the dopant material of the luminescent material, a material represented by the formula (2): 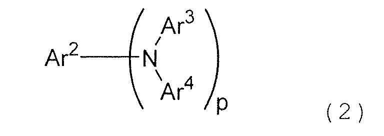 wherein Ar² to Ar⁴ are each a substituted or unsubstituted aromatic group with 6 to 50 nucleus carbon atoms, or a substituted or unsubstituted styryl group; and p is an integer of 1 to 4.

Examples of the substituted or unsubstituted aromatic group with 6 to 50 nucleus carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-fluorenyl, 9,9-dimethyl-2-fluorenyl and 3-fluorantenyl groups.

Preferred examples thereof include phenyl, 1-naphthyl, 2-naphthyl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, o-tolyl, m-tolyl, p-tolyl, p-t-butylphenyl, 2-fluorenyl, 9,9-dimethyl-2-fluorenyl and 3-fluorantenyl groups.

Examples of the substituted or unsubstituted styryl group include 2-phenyl-1-vinyl, 2,2-diphenyl-1-vinyl, and 1,2,2-triphenyl-1-vinyl groups.

p is an integer of 1 to 4; provided that Ar³s, as well as Ar⁴s, may be the same as or different from each other when p is 2 or more.

Specific examples of the compounds represented by the formula (2) are illustrated below.

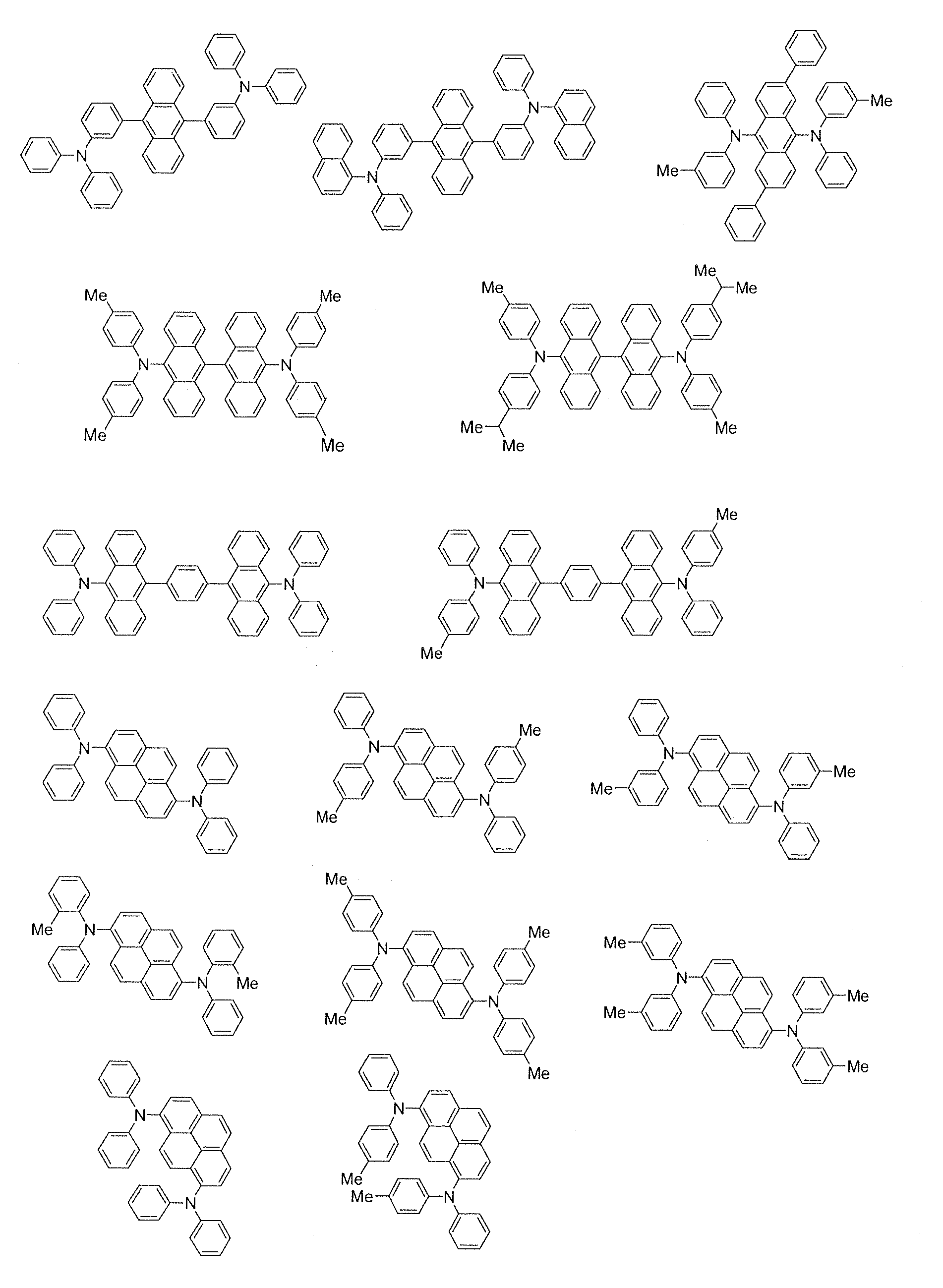

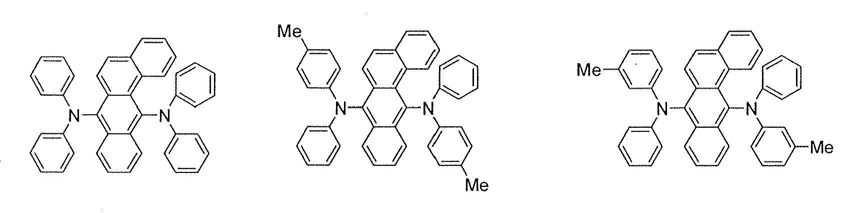

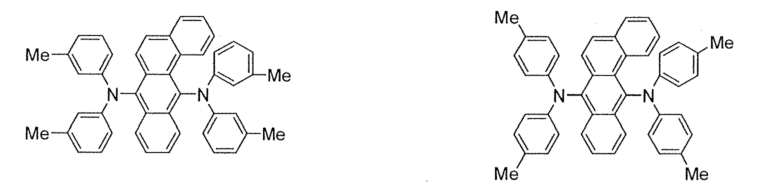

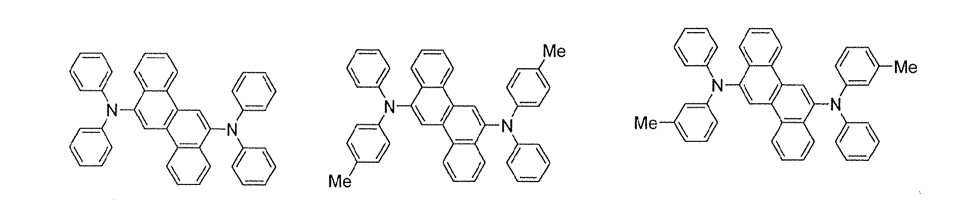

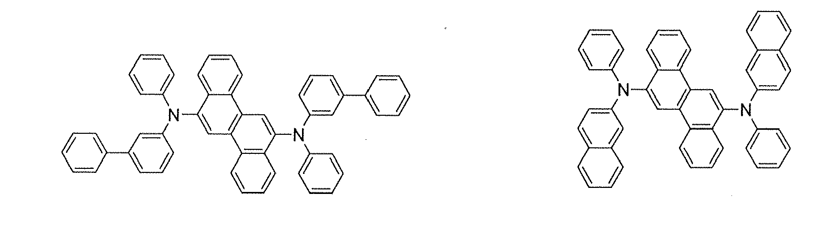

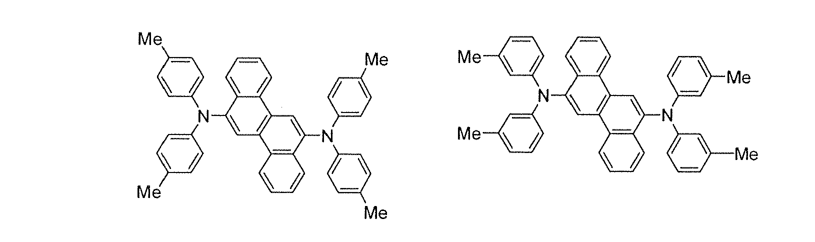

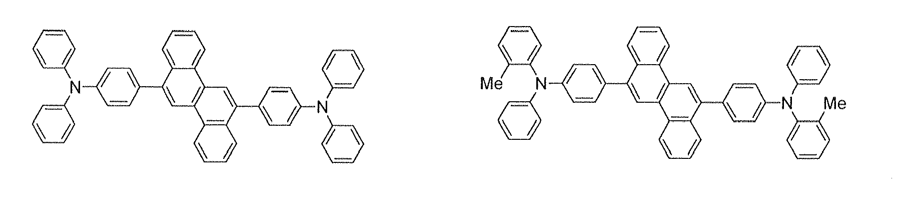

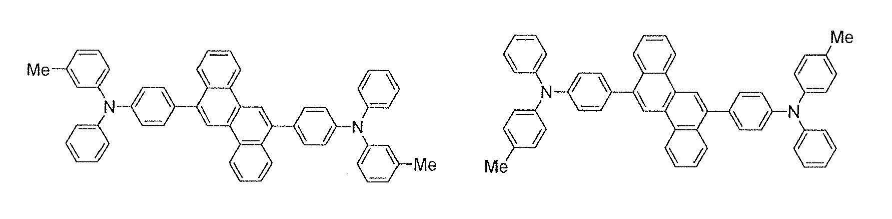

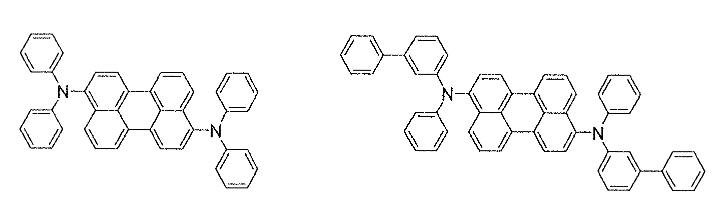

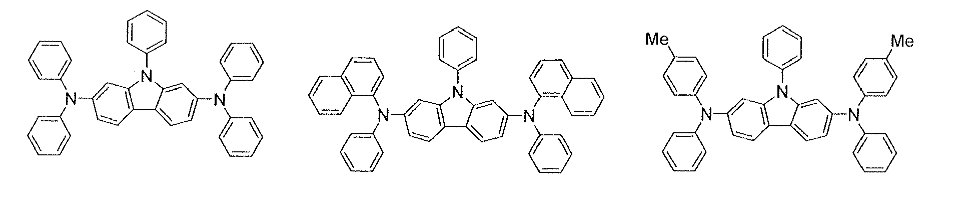

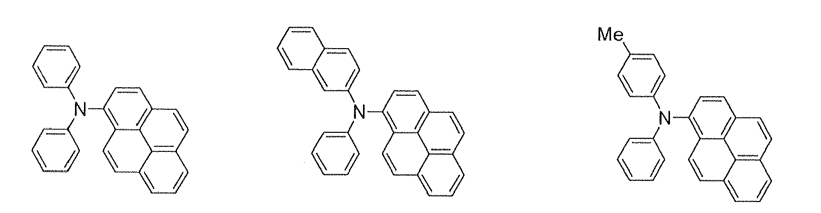

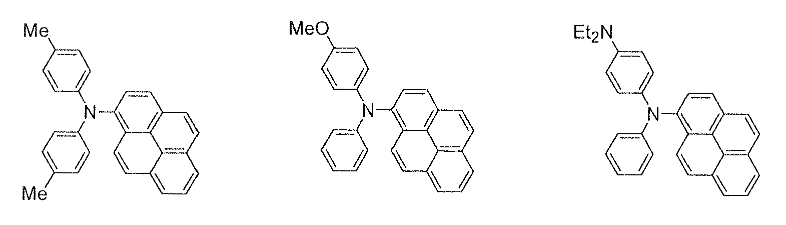

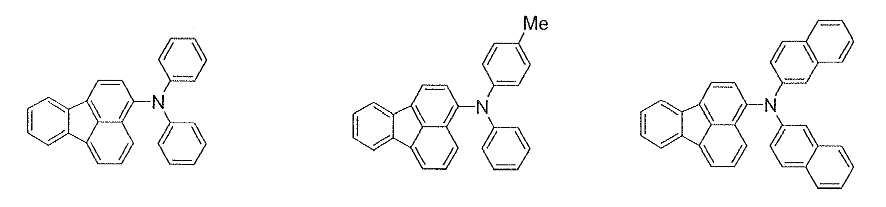

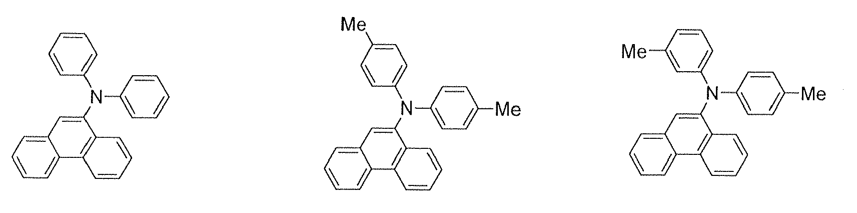

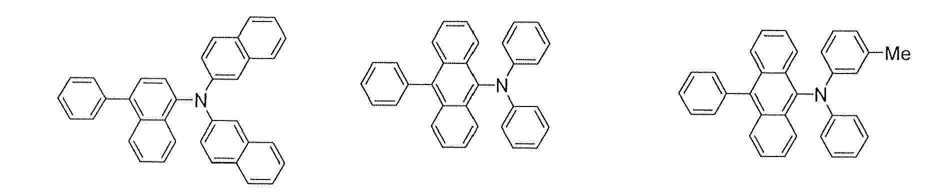

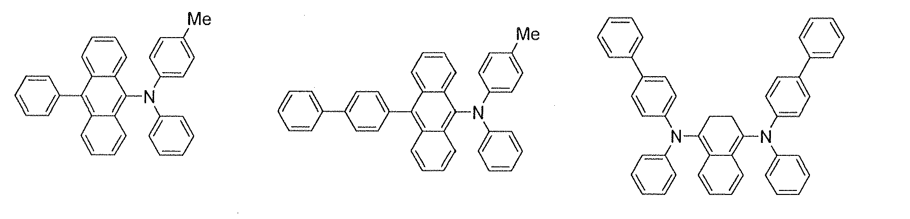

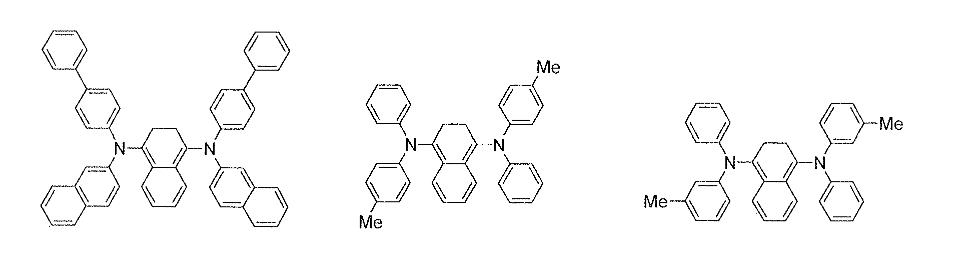

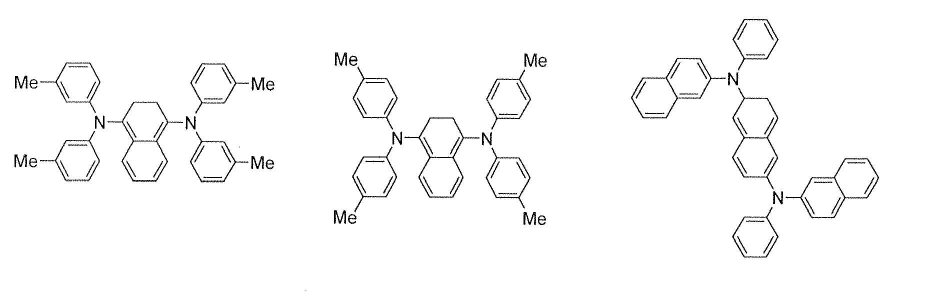

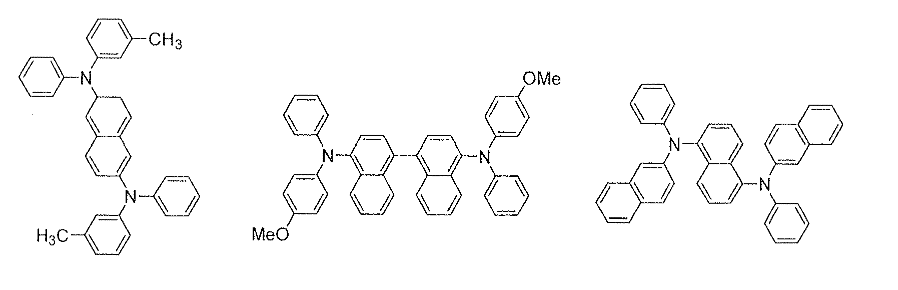

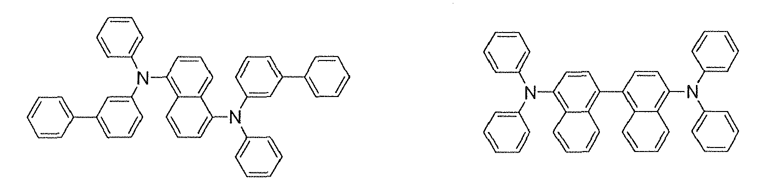

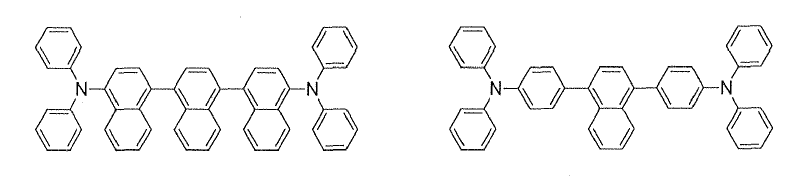

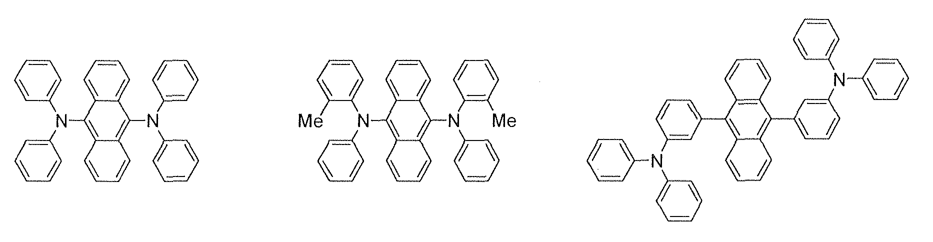

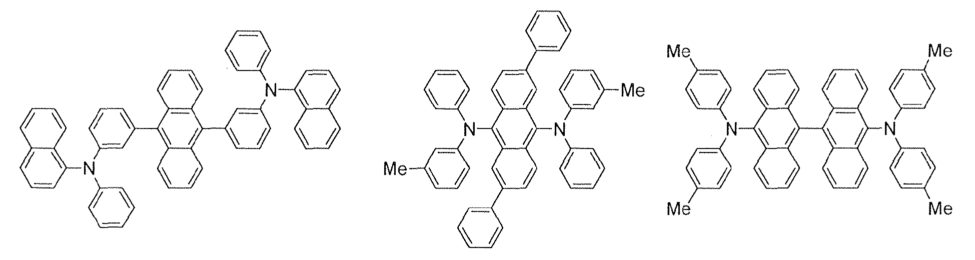

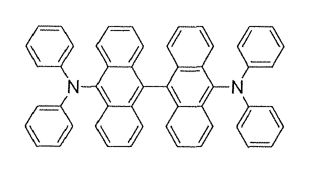

### (4) Hole-transporting layer

In the invention, a hole-transporting layer may be provided between an emitting layer and a hole-injecting layer. The hole-transporting layer is preferably made of a material that can transport holes to the emitting layer at a lower electric field intensity. Namely, the hole mobility thereof is preferably 10⁻⁴ cm²/V·second or more when an electric field of 10⁴ to 10⁶ V/cm is applied.

The material for forming the hole-transporting layer can be arbitrarily selected from materials which have been widely used as a hole-transporting material among photoconductive materials and known materials used in a hole-transporting layer of organic EL devices.

Specific examples thereof include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrozoline derivatives and pyrozolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925 , and others), arylamine derivatives (see USP Nos. 3,567,450, 3,180,703, 3,240,597, 3,658,520, 4,232,103, 4, 175, 961 and 4,012,376, JP-B-49-35702 and 39-27577, JP-A-55-144250, 56-119132 and 56-22437, DE1, 110, 518, and others), amino-substituted chalcone derivatives (see USP No.3, 526, 501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilnene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive macromolecular oligomers (in particular thiophene oligomers) disclosed in JP-A-1-211399.

The hole-transporting layer can be formed from the above-mentioned compounds by a known method such as vacuum deposition, spin coating, casting or LB technique. The thickness of hole-transporting layer is not particularly limited, and is preferably from 5 nm to 5 µm, more preferably from 5 nm to 40 nm. The hole-transporting layer may be a single layer made of one or more out of the above-mentioned materials. The layer may be stacked hole-transporting layers made of different compounds.

### (5) Hole-injecting layer

The same substances as those used for the hole-transporting layer can be used as the material of the hole-injecting layer. The following is preferably used: porphyrin compounds (disclosed in JP-A-63-2956965 and others), aromatic tertiary amine compounds and styrylamine compounds (see USP Nos. 4,127,412, JP-A-53-27033, 54-58445, 54-149634, 54-64299, 55-79450, 55-144250, 56-119132, 61-295558, 61-98353 and 63-295695, and others), in particular, the aromatic tertiary amine compounds.

The following can also be given as examples: 4,4'-bis(N-(1-naphthyl)-N-phenylamino)biphenyl (hereinafter referred to as NPD), which has in the molecule thereof two condensed aromatic rings and is disclosed in USP No. 5,061,569, and 4,4',4"-tris(N-(3-methylphenyl)-N-phenylamino)triphenylamine (hereinafter referred to as MTDATA), wherein three triphenylamine units are linked to each other in a star-burst form and which is disclosed in JP-A-4-308688.

Inorganic compounds such as p-type Si and p-type SiC as well as aromatic dimethylidene type compounds can also be used as the material of the hole-injecting layer. The organic semiconductor layer, which is also a hole-injecting layer, is a layer for helping the injection of holes or electrons into the emitting layer, and is preferably a layer having an electroconductivity of 10⁻¹⁰ S/cm or more. The material of such an organic semiconductor layer may be an electroconductive oligomer such as thiophene-containing oligomers or arylamine-containing oligomers disclosed in JP-A-8-193191, or an electroconductive dendrimer such as arylamine-containing dendrimers.

The hole-injecting layer of the organic EL device of Embodiment 1 of the invention can be formed by adding the above-mentioned metal oxides to these hole-injecting layer materials.

The hole-injecting layer can be formed from the above-mentioned compounds by a known method such as vacuum deposition, spin coating, casting or LB technique.

The thickness of the hole-injecting layer is preferably 40 nm to 1000 nm in order to avoid damage during the formation of an anode. It is more preferably 60 to 300 nm, still more preferably 100 to 200 nm.

The hole-injecting layer may be a single layer made of one kind or two or more kinds of the above-mentioned materials. The hole-injecting layer may be stacked hole-injecting layers made of different compounds.

### (6) Electro-transporting layer

In the invention, an electron-transporting layer may be provided between the cathode and the emitting layer.

The thickness of electron-transporting layer may be properly selected from several nm to several µm but is preferably selected such that the electron mobility is 10⁻⁵ cm²/Vs or more when an electric field of 10⁴ to 10⁶ V/cm is applied.

The material used in the electron-transporting layer is preferably a metal complex of 8-hydroxyquinoline or a derivative thereof.

Specific examples of the above-mentioned metal complex of 8-hydroxyquinoline or derivative thereof include metal chelate oxynoid compounds containing a chelate of oxine (generally, 8-quinolinol or 8-hydroxyquinoline).

For example, Alq described as the emitting material can be used for the electron-injecting layer.

Examples of oxadiazole derivatives include electron-transferring compounds represented by the following general formulas. 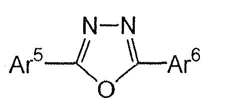 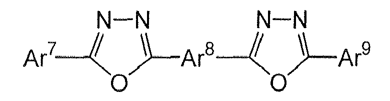 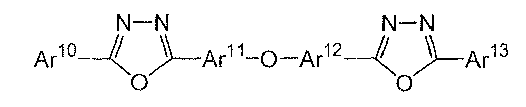 wherein Ar⁵, Ar⁶, Ar⁷, Ar⁹, Ar¹⁰ and Ar¹³ each represent a substituted or unsubstituted aryl group and may be the same or different, and Ar⁸, Ar¹¹ and Ar¹² represent a substituted or unsubstituted arylene group and may be the same or different.

Examples of the aryl group include phenyl, biphenyl, anthranyl, perylenyl, and pyrenyl groups. Examples of the arylene group include phenylene, naphthylene, biphenylene, anthranylene, perylenylene, and pyrenylene groups. Examples of the substituent include alkyl groups with 1 to 10 carbon atoms, alkoxy groups with 1 to 10 carbon atoms, and a cyano group. The electron-transferring compounds are preferably ones having capability of forming a thin film.

Specific examples of the electron-transferring compounds include the following.

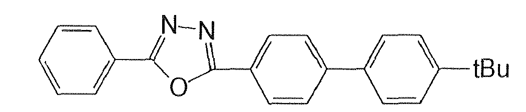

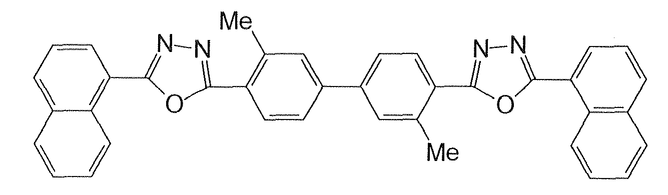

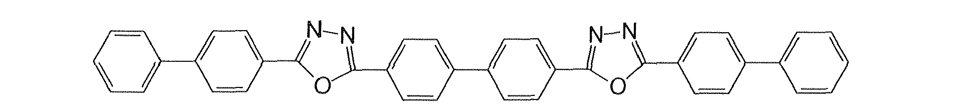

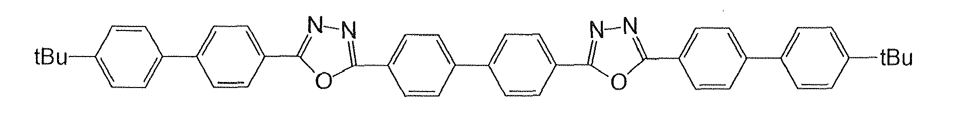

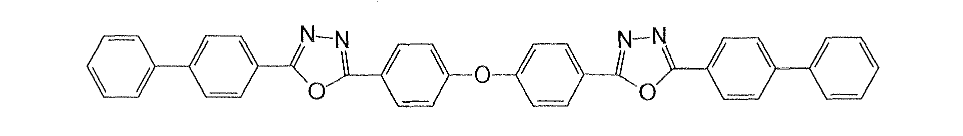

Nitrogen-containing heterocyclic derivatives represented by the following formula: 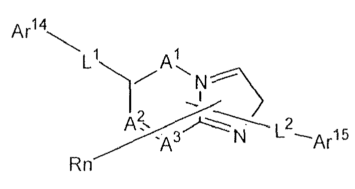 wherein A¹ to A³ are independently a nitrogen atom or a carbon atom;
R is an aryl group having 6 to 60 carbon atoms which may have a substituent, a heteroaryl group having 3 to 60 carbon atoms which may have a substituent, an alkyl group having 1 to 20 carbon atoms, a haloalkyl group having 1 to 20 carbon atoms or an alkoxy group having 1 to 20 carbon atoms; n is an integer of 0 to 5; when n is an integer of 2 or more, Rs may be the same or different; and
adjacent Rs may be bonded to each other to form a substituted or unsubstituted carbon aliphatic ring or a substituted or unsubstituted carbon aromatic ring;
Ar¹⁴ is a substituted or unsubstituted aryl group having 6 to 60 carbon atoms or a substituted or unsubstituted heteroaryl group having 3 to 60 carbon atoms;
Ar¹⁵ is a hydrogen atom, an alkyl group having 1 to 20 carbon atoms, a haloalkyl group having 1 to 20 carbon atoms, an alkoxy group having 1 to 20 carbon atoms, an aryl group having 6 to 60 carbon atoms which may have a substituent or a heteroaryl group having 3 to 60 carbon atoms which may have a substituent;
provided that one of Ar¹⁴ and Ar¹⁵ is a substituted or unsubstituted condensed ring having 10 to 60 carbon atoms or a substituted or unsubstituted hetero condensed ring having 3 to 60 carbon atoms; and
L¹ and L² are independently a single bond, a substituted or unsubstituted condensed ring having 6 to 60 carbon atoms, a substituted or unsubstituted hetero condensed ring having 3 to 60 carbon atoms or a substituted or unsubstituted fluorenylene group.

Nitrogen-containing heterocyclic derivatives represented by the following formula:

HAr-L³-Ar¹⁶-Ar¹⁷

wherein HAr is a nitrogen-containing heterocyclic ring with 3 to 40 carbon atoms which may have a substituent;
L³ is a single bond, an arylane group with 6 to 60 carbon atoms which may have a substituent, a heteroarylane group with 3 to 60 carbon atoms which may have a substituent or a fluorenylene group which may have a substituent;
Ar¹⁶ is a bivalent aromatic hydrocarbon group with 6 to 60 carbon atoms which may have a substituent; and
Ar¹⁷ is an aryl group with 6 to 60 carbon atoms which may have a substituent or a heteroaryl group with 3 to 60 carbon atoms which may have a substituent.

An electroluminescent device using a silacyclopentadiene derivative represented by the following formula, disclosed in JP-A-09-087616: 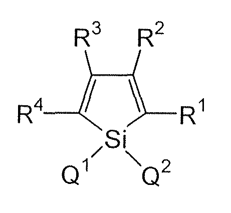 wherein Q¹ and Q² are each a saturated or unsaturated hydrocarbon group with 1 to 6 carbon atoms, an alkoxy group, an alkenyloxy group, an alkynyloxy group, a hydroxyl group, a substituted or unsubstituted aryl group, or a substituted or unsubstituted hetero ring, or Q¹ and Q² are bonded to each other to form a saturated or unsaturated ring; R¹ to R⁴ are each a hydrogen atom, a halogen atom, a substituted or unsubstituted alkyl group with 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoyl group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group or a cyano group, or adjacent groups of R¹ to R⁴ may be joined to form a substituted or unsubstituted condensed ring.

Silacyclopentadiene derivatives represented by the following formula, disclosed in JP-A-09-194487: 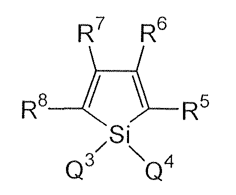 wherein Q³ and Q⁴ are each a saturated or unsaturated hydrocarbon group with 1 to 6 carbon atoms, an alkoxy group, an alkenyloxy group, an alkynyloxy group, a substituted or unsubstituted aryl group, or a substituted or unsubstituted heterocyclic group, or Q³ or Q⁴ are bonded to each other to form a saturated or unsaturated ring; and R⁵ to R⁸ are each a hydrogen atom, a halogen atom, a substituted or unsubstituted alkyl group with 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoyl group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group, or a cyano group, or adjacent substituents of R⁵ to R⁸ are bonded to form a substituted or unsubstituted condensed ring structure: provided that in the case where R⁵ and R⁸ are each a phenyl group, Q³ and Q⁴ are neither an alkyl group nor a phenyl group; in the case where R⁵ and R⁸ are each a thienyl group, Q³, Q⁴, R⁶ and R⁷ do not form the structure where Q³ and Q⁴ are a monovalent hydrocarbon group and at the same time R⁶ and R⁷ are an alkyl group, an aryl group or an alkenyl group, or are aliphatic groups which form a ring by bonding to each other; in the case where R⁵ and R⁸ are a silyl group, R⁶, R⁷, Q³ and Q⁴ are each neither a monovalent hydrocarbon group with 1 to 6 carbon atoms nor a hydrogen atom; and in the case where a benzene ring is condensed at the positions of R⁵ and R⁶, Q³ and Q⁴ are neither an alkyl group nor a phenyl group.

Borane derivatives represented by the following formula, disclosed in JP-A1-2000-040586: 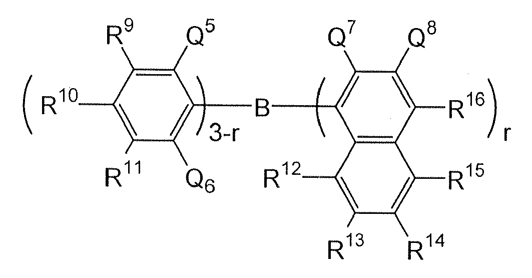 wherein R⁹ to R¹⁶ and Q⁸ are each a hydrogen atom, a saturated or unsaturated hydrocarbon group, an aromatic group, a heterocyclic group, a substituted amino group, a substituted boryl group, an alkoxy group or an aryloxy group; Q⁵, Q⁶ and Q⁷ are each a saturated or unsaturated hydrocarbon group, an aromatic group, a heterocyclic group, a substituted amino group, an alkoxy group or an aryloxy group; the substituents of Q⁷and Q⁸ may be bonded to each other to form a condensed ring; r is an integer of 1 to 3, and Q⁷s may be different from each other when r is 2 or more; provided that excluded are the compounds where r is 1, Q⁵, Q⁶ and R¹⁰ are each a methyl group and R¹⁶ is a hydrogen atom or a substituted boryl group, and the compounds where r is 3 and Q⁷ is a methyl group.

Compounds represented by the following formula, disclosed in JP-A-10-088121: 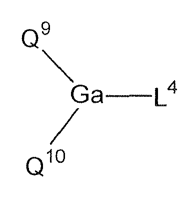 wherein Q⁹ and Q¹⁰ are independently a ligand represented by the following formula (3); and L⁴ is a halogen atom, a substituted or unsubstituted alkyl group, a substituted or unsubstituted cycloalkyl group, a substituted or unsubstituted aryl group, a substituted or unsubstituted heterocyclic group, -OR¹⁷ wherein R¹⁷ is a hydrogen atom, a substituted or unsubstituted alkyl group, a substituted or unsubstituted cycloalkyl group, a substituted or unsubstituted aryl group or a substituted or unsubstituted heterocyclic group, or -O-Ga-Q¹¹(Q¹²) wherein Q¹¹ and Q¹² are the same legands as Q⁹ and Q¹⁰. 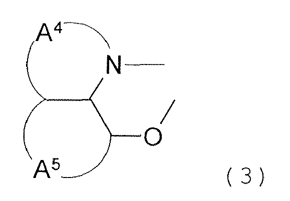 wherein rings A⁴ and A⁵ are each a 6-membered aryl ring structure which may have a substituent, and are condensed to each other.

The metal complexes have the strong nature of an n-type semiconductor and large ability of injecting electrons. Further the energy generated at the time of forming a complex is small so that a metal is then strongly bonded to ligands in the complex formed and the fluorescent quantum efficiency becomes large as the emitting material.

Specific examples of substituents of the rings A⁴ and A⁵ which form the ligands of the above formula include halogen atoms such as chlorine, bromine, iodine and fluorine; substituted or unsubstituted alkyl groups such as methyl, ethyl, propyl, butyl, sec-butyl, tert-butyl, pentyl, hexyl, heptyl, octyl, stearyl and trichloromethyl; substituted or unsubstituted aryl groups such as phenyl, naphthyl, 3-methylphenyl, 3-methoxyphenyl, 3-fluorophenyl, 3-trichloromethylphenyl, 3-trifluoromethylphenyl and 3-nitrophenyl; substituted or unsubstituted alkoxy groups such as methoxy, n-butoxy, tert-butoxy, trichloromethoxy, trifluoroethoxy, pentafluoropropoxy, 2,2,3,3-tetrafluoropropoxy, 1,1,1,3,3,3-hexafluoro-2-propoxy and 6-(perfluoroethyl)hexyloxy; substituted or unsubstituted aryloxy groups such as phenoxy, p-nitrophenoxy, p-tert-butylphenoxy, 3-fluorophenoxy, pentafluorophenyl and 3-trifluoromethylphenoxy; substituted or unsubstituted alkylthio groups such as methythio, ethylthio, tert-butylthio, hexylthio, octylthio and trifruoromethyltio; substituted or unsubstituted arylthio groups such as phenylthio, p-nitrophenylthio, p-tert-butylphenylthio, 3-fluorophenylthio, pentafluorophenylthio and 3-trifluoromethylphenylthio; a cyano group; a nitro group, an amino group; mono or di-substituted amino groups such as methylamino, dimethylamino, ethylamino, diethylamino, dipropylamino, dibutylamino and diphenylamino; acylamino groups such as bis(acetoxymethyl)amino, bis(acetoxyethyl)amino, bis (acetoxypropyl) amino and bis (acetoxybutyl)amino; a hydroxy group; a siloxy group; an acyl group; carbamoyl groups such as methylcarbamoyl, dimethylcarbamoyl, ethylcarbamoyl, diethylcarbamoyl, propylcarbamoyl, butylcarbamoyl and phenylcarbamoyl; a carboxylic group; a sulfonic acid group; an imido group; cycloalkyl groups such as cyclopentyl and cyclohexyl; aryl groups such as phenyl, naphthyl, biphenyl, anthranyl, phenanthryl, fluorenyl and pyrenyl; and heterocyclic groups such as pyridinyl, pyrazinyl, pyrimidinyl, pryidazinyl, triazinyl, indolinyl, quinolinyl, acridinyl, pyrrolidinyl, dioxanyl, piperidinyl, morpholidinyl, piperazinyl, triathinyl, carbazolyl, furanyl, thiophenyl, oxazolyl, oxadiazolyl, benzooxazolyl, thiazolyl, thiadiazolyl, benzothiazolyl, triazolyl, imidazolyl, benzoimidazolyl and puranyl. Moreover the above-mentioned substituents may be bonded to each other to form a six-membered aryl or heterocyclic ring.

### (7) Hole-injecting layer

In the invention, an electron-injecting layer which is formed of an insulator or a semiconductor may be provided between a cathode and an electron-injecting layer or between a cathode and an emitting layer. By providing such an electron-injecting layer, current leakage can be effectively prevented to improve the injection of electrons.

As the insulator, a single metal compound or a combination of metal compounds selected from alkali metal calcogenides, alkaline earth metal calcogenides, halides of alkali metals, halides of alkaline earth metals, aluminum oxide, aluminum nitride, titanium oxide, silicon dioxide, germanium oxide, silicon nitride, boron nitride, molybdenum oxide, ruthenium oxide and vanadium oxide can be preferably used. Among these metal compounds, the alkali metal calcogenides or alkaline earth metal calcogenides are preferred in view of the injection of electrons. Preferable alkali metal calcogenides include Li₂O, LiO, Na₂S, Na₂Se and NaO. Preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as CaF₂, BaF₂, SrF₂, MgF₂ and BeF₂ and halides other than fluorides.

Examples of the semiconductor for forming the electron-injecting layer include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof.

The electron-injecting layer is preferably microcrystalline or amorphous. Because a more uniform thin film can be formed to reduce pixel defects such as dark spots.

Two or more electron-injecting layers may be stacked.

### (8) Reducing dopant

A reducing dopant can be contained in an electron transporting region or an interface region between a cathode and an organic layer. The reducing dopant is defined as a substance which can reduce electron-transporting compounds. Various substances having reducibility can be used. The following can be preferably used: alkali metals, alkaline earth metals, rare earth metals, oxides of alkali metals, halides of alkali metals, oxides of alkaline earth metals, halides of alkaline earth metals, oxides of rare earth metals, halides of rare earth metals, organic complexes of alkali metals, organic complexes of alkaline earth metals and organic complexes of rare earth metals.

Preferable examples of the reducing dopant are alkali metals such as Na (work function: 2.36 eV), K (work function: 2.28 eV), Rb (work function: 2.16 eV) and Cs (work function: 1.95 eV) or alkaline earth metals such as Ca (work function: 2.9 eV), Sr (work function: 2.0 to 2.5 eV) and Ba (work function: 2.52 eV). Among these, the reducing dopant is preferably K, Rb or Cs, more preferably Rb or Cs, and even more preferably Cs. Combinations of two or more of these alkali metals are preferable. Combinations with Cs, for example, Cs and Na, Cs and K, Cs and Rb or Cs, Na and K are particularly preferable.

### (9) Cathode

For the cathode, the following may be preferred: an electrode substance made of a metal, an alloy, an electroconductive compound, or a mixture thereof which has a small work function (4 eV or less). Specific examples of the electrode substance include sodium, sodium-potassium alloy, magnesium, lithium, magnesium/silver alloy, aluminum/aluminum oxide, aluminum/lithium alloy, indium, and rare earth metals.

The cathode preferably contains a metal oxide.

As the metal oxide, at least one metal oxide selected from LiₓTi₂O₄, LiₓV₂O₄, ErₓNbO₃, LaₓTiO₃, SrₓVO₃, CaₓCrO₃ and SrₓCrO₃ (X is 0.2 to 5) is exemplified. As the metal oxide, at least one metal oxide selected from AₓMoO₃ (A is K, Cs, Rb, Sr, Na, Li or Ca) (x is 0.2 to 5) and AₓV₂O₅ (A is K, Cs, Rb, Sr, Na, Li or Ca) (x is 0.2 to 5) is exemplified.

The cathode more preferably contains at least one metal selected from alkali metals and alkaline earth metals to improve electron injecting ability. Preferred metals include Na, K, Cs and Mg.

The cathode can be formed by making the electrode substances into a thin film by vapor deposition, sputtering or some other method.

In the case where luminescence from the emitting layer is outcoupled through the cathode, the transmittance of the cathode to luminescence is preferably 10% or more, more preferably 30% or more, even more preferably 50% or more.

The sheet resistance of the cathode is preferably 1000 Ω/□ or less, more preferably 800 Ω/□ and even more preferably 600 Ω/□.

The film thickness of the cathode is not limited, and is preferably 10 nm to 1 µm, more preferably from 50 to 200 nm.

In the case where luminescence is outcoupled through the anode, the cathode is preferably a reflecting electrode.

### (10) Insulative layer

In the organic EL device, pixel defects due to leakage or a short circuit are easily generated since an electric field is applied to the super thin film. In order to prevent this, it is preferred to insert an insulator thin layer between the cathode and organic layers.

Examples of the material used in the insulative layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide.

In the invention, a mixture or multilayer thereof may be used.

### (11) Protecting layer

A protecting layer is formed so as to protect an organic layer when forming an anode.

In general, metals including Ag and Au, and alloys thereof, which have a greater transparency, are used. In addition to these, a semiconductor or an insulator may be used to achieve the above object.

Specifically, the materials exemplified for the insulator layer and the materials exemplified for the metal oxides are preferably used. Examples of the semiconductor include CdSe, CdS, ZnS and ZnSe.

For the protecting layer, these materials may be used individually or in a mixture thereof. These materials may also be used in combination with materials for other applications.

Usually, the film thickness of the protecting layer is preferably in the range of several nanometers to several tens nanometers, particularly preferably of 1 nm to 10 nm to enhance its transparency.

### (12) Metal layer

A metal layer can be provided between a conductive film forming an anode and a protecting film, a metal oxide layer and an anode, or an emitting layer and a metal oxide layer.

The metal layer can be formed from an alloy containing at least one metal selected from Mg, Ag and Zr.

The film thickness is not limited, but preferably from 0.1 nm to 10 µm, and more preferably from 1 nm to 15 nm.

### (13) Example of fabricating organic EL device

An example of producing the organic EL device of the first embodiment will be described below which has a structure wherein the following are successively formed on a substrate: cathode/electron-transporting layer/emitting layer/hole-injecting layer/protecting layer/anode.

A thin film made of a cathode material is formed into a thickness of 1 µm or less, preferably 10 to 200 nm on a substrate by vapor deposition, sputtering or some other method, thereby forming a cathode. Next, an electron-transporting layer is formed on this cathode. The electron-transporting layer can be formed by vacuum deposition, spin coating, casting, LB technique, or some other method. Vacuum deposition is preferred since a homogenous film is easily obtained and pinholes are not easily generated. In the case where the electron-transporting layer is formed by vacuum deposition, conditions for the deposition vary depending on a compound to use (material for the electron-transporting layer), an intended crystal structure or recombining structure of the electron-transporting layer, and so on. In general, the conditions are appropriately selected from the following: deposition source temperatures of 50 to 450°C, vacuum degrees of 10⁻⁷ to 10⁻³ torr, vapor deposition rates of 0.01 to 50 nm/second, substrate temperatures of -50 to 300°C, and film thicknesses of 5 nm to 5 µm.

Next, an emitting layer is disposed on the electron-transporting layer. The emitting layer can be formed by making a desired organic luminescent material into a thin film by vacuum deposition, sputtering, spin coating, casting or some other method. Vacuum deposition is preferred since a homogenous film is easily obtained and pinholes are not easily generated. In the case where the emitting layer is formed by vacuum deposition, conditions for the deposition, which vary depending on a compound to use, can be generally selected from conditions similar to those for the electron-transporting layer.

Next, a hole-injecting layer is formed on this emitting layer. Like the electron-transporting layer and the emitting layer, the layer is preferably formed by vacuum deposition since a homogenous film need be obtained. Conditions for the deposition can be selected from conditions similar to those for the electron-transporting layer and the emitting layer.

A protecting layer is formed in a thickness of several nm to several tens nm on this hole-injecting material. This protecting layer can be formed using various methods, specifically vacuum deposition, sputtering, electron beam deposition, etc. When the protecting layer is formed by vacuum deposition, the deposition conditions vary depending on a compound to use (material for the hole-injecting layer), an intended crystal structure or recombining structure of the protecting layer, and so on. In general, the conditions are appropriately selected from the following: deposition source temperatures of 500 to 1000 °C, vacuum degrees of 10⁻⁷ to 10⁻³ torr, vapor deposition rates of 0.01 to 50 nm/second, substrate temperatures of -50 to 300°C, and film thicknesses of 1 nm to 20 nm.

Lastly, an anode is stacked thereon to obtain an organic EL device.

The anode is made of a metal, and vapor deposition or sputtering may be used. However, vacuum deposition is preferred in order to protect underlying organic layers from being damaged when the anode is formed.

An example of the production of the organic EL device of the second embodiment will be described below which has a structure wherein the following are successively formed on a substrate:
cathode/electron-transporting layer/emitting layer/hole-injecting layer/metal oxide layer/anode.

The same steps from a cathode to a hole-injecting layer as in the above example of the production of the first embodiment are repeated.

A metal oxide layer is formed in a thickness of several nm to several tens nm on the hole-injecting layer. This metal oxide layer can be formed using various methods, specifically vacuum deposition, sputtering, electron beam deposition, etc. Vacuum deposition is preferred due to less damage to the hole-injecting layer. When the metal oxide layer is formed by vacuum deposition, the deposition conditions vary depending on a compound to use, an intended crystal structure or recombining structure of the metal oxide layer, and so on. In general, the conditions are appropriately selected from the following: deposition source temperatures of 50 to 500 °C, vacuum degrees of 10⁻⁷ to 10⁻³ torr, vapor deposition rates of 0.01 to 50 nm/second, substrate temperatures of -50 to 300°C, and film thicknesses of 1 nm to 20 nm.

An anode is formed on the metal oxide layer in the same way as in the above-mentioned production example.

For the organic EL element production that has been described above, it is preferred that the formation from the cathode to the anode is continuously carried out, using only one vacuuming operation.

The method for forming each of the layers in the organic EL device of the invention is not particularly limited. A known forming method such as vacuum deposition or spin coating can be used. An organic thin layer used in the organic EL device of the invention can be formed in known ways such as vacuum deposition, molecular beam deposition (MBE method), or application of a solution in which a material is dissolved in a solvent such as dipping, spin coating, casting, bar coating or roll coating.

The film thickness of each of the organic layers in the organic EL device of the invention is not particularly limited. In general, defects such as pinholes are easily generated when the film thickness is too small. Conversely, a high applied voltage becomes necessary, leading to worse efficiency when the film thickness is too large. Usually, therefore, the film thickness is preferably in the range of several nanometers to one micrometer.

### [Examples]

### Example 1

A glass substrate, 25 mm x 75 mm x 1.1 mm thick, (manufactured by Geomatics Co.) was subjected to ultrasonic cleaning in isopropyl alcohol for 5 minutes, followed by UV ozone cleaning for 30 minutes.

The cleaned glass substrate was mounted in a substrate holder in a vacuum deposition device. Metal A1 was deposited in a thickness of 150 nm to form a metal cathode.

Next, LiF was deposited in a thickness of 1 nm on the cathode as an electron-injecting layer.

Next, Alq was deposited in a thickness of 20 nm. This film functioned as an electron-transporting layer.

Next, H1 illustrated below was deposited to form a 40 nm thick film on this electron-transporting layer. At the same time, as a luminescent molecule, a dopant D1 illustrated below was co-deposited. The deposition ratio was H1:D1= 40:2 (weight ratio). This film functioned as an emitting layer.

An N,N,N',N'-tetra(4-biphenyl)-diaminobiphenylene layer (TBDB layer hereinafter) was formed in a thickness of 20 nm on this emitting layer. This film functioned as a hole-transporting layer.

Further, molybdenum trioxide and TBDB were co-deposited on this hole-transporting layer. The deposition rate ratio was such that the thickness ratio of molybdenum trioxide to TBDB was 3 nm to 60 nm. The thickness of the film was 60 nm. This film functioned as a hole-injecting layer.

Next, molybdenum trioxide was heated using a resistant heating boat and a 5 nm thick film was formed on the hole-injecting layer. This film was a protecting layer.

Lastly, IZO was deposited by sputtering at room temperature in a thickness of 150 nm on the protecting layer to form a transparent anode, thereby fabricating an organic EL device.

The voltage required for applying a current density of 10 mA/cm² to this organic EL device and half life thereof at an initial luminance of 1,000 nit are shown in Table 1.

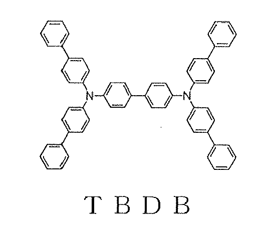

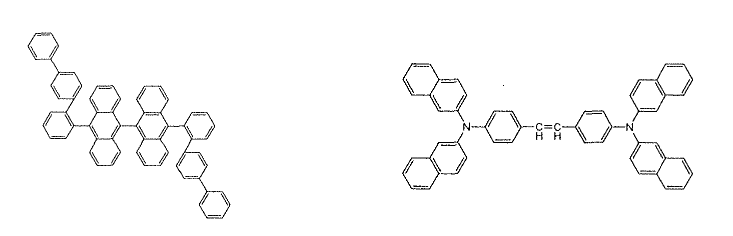

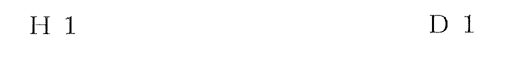

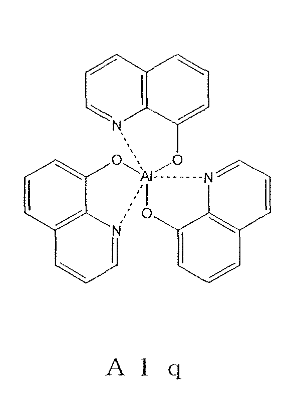

### Example 2

An organic EL device was fabricated in the same way as in Example 1 except that the protecting layer was not formed and the film thickness of the hole-injecting layer is 120 nm.

The voltage required for applying a current density of 10 mA/cm² to this organic EL device and half life thereof at an initial luminance of 1,000 nit are shown in Table 1.

### Comparative example 1

An organic EL device was fabricated in the same way as in Example 1 except that the metal oxide of the hole-injecting layer was not co-depositied.

The voltage required for applying a current density of 10 mA/cm² to this organic EL device and half life thereof at an initial luminance of 1,000 nit are shown in Table 1.

**Table 1**

| | Driving voltage (@10mA/cm²) | Half life (L0=1,000nit) |
|---|---|---|
| Example 1 | 5.8V | 6200h |
| Example 2 | 6.1V | 5800h |
| Comparative Example 1 | 7.1V | 4300h |

### Example 3

A glass substrate, 25 mm x 75 mm x 1.1 mm thick, having Ag (thickness: 20 nm) and ITO (thickness: 130 nm) electrodes (manufactured by Geomatics Co.) was subjected to ultrasonic cleaning in isopropyl alcohol for 5 minutes and then in distilled water having an electrical resistance of 20 MΩm for 5 minutes, and further ultrasonic cleaning in isopropyl alcohol for 5 minutes. The resultant substrate was removed and dried. Immediately thereafter, the substrate was subjected to UV ozone cleaning for 30 minutes with an UV ozone device manufactured by Opto Films Lab.

The cleaned glass substrate with electrode was mounted in a substrate holder in a vacuum deposition device. The inside of the device was vacuumed to 1 x 10⁻⁵ Pa.

Firstly, Alq and Li were deposited to form a 20 nm thick film at a deposition rate of 0.1 nm/sec and 0.01 nm/sec respectively on the surface on which the transparent electrode lines were formed, so as to cover the electrode.

A host material (H1) was deposited at a deposition rate of 0.2 nm/sec to form a 40 nm thick film thereon. Then, a dopant (D1) was deposited as a luminescent molecule at a deposition rate of 0.01 nm/sec simultaneously. This layer functioned as an emitting layer.

Furthermore, an N,N,N',N'-tetra(4-biphenyl)-diaminobiphenylene (TBDB) layer having a thickness of 20 nm was formed at a deposition rate of 0.1 nm/sec. This film functioned as a hole-transporting layer.

A N,N'-bis(N,N'-diphenyl-4-aminoplienyl)-N,N-diphenyl-4,4'-diamino-1,1'-biphenyl (TPD 232) film was formed in a thickness of 60 nm at a deposition rate of 0.1 nm/sec on the TBDB layer. This TPD 232 film functioned as a hole-injecting layer.

After the formation of the TPD 232 film, a MoO₃ film was formed in a thickness of 10 nm at a deposition rate of 0.02 nm/sec on this TPD 232 film.

Next, an ITO film was formed in a thickness of 100 nm at a deposition rate of 0.4 nm/s.

Then, the initial performance of this organic EL device was measured at a current density of 1 mA/cm², using the light-reflecting electrode as a cathode. The results were a driving voltage of 4.5 V, 10 cd/A, and CIEx, y = (0.16, 0.26).

For a current linkage, the current value was measured by applying voltage of 5 V in reverse bias. The current linkage was 2x10⁻⁹ A/cm².

The lifetime was measured at room temperature by driving with a constant direct current. At this time a current was adjusted to the current value at an initial luminance of 3000 nit and the current was continuously applied. A half-life is a period of time until the initial luminance was reduced by half. The lifetime was 2000 hr.

The results are shown in Table 2.

### Comparative example 2

An organic EL device was fabricated in the same way as in Example 3 except that Au was used instead of MoO₃ to form a film in a thickness of 5 nm at a deposition rate of 0.05 nm/sec.

The initial performance was a driving voltage of 7 V, 6.0 cd/A, and CIEx, y = (0.16, 0.25). The current linkage was 1x10⁻⁶ A/cm². The half-life was 1000 hr.

### Example 4

An organic EL device was fabricated in the same way as in Example 3 except that after the deposition of MoO₃, Mg and Ag were co-deposited to form a 1.5 nm thick film at a deposition rate of 1.5 nm/sec and 0.1 nm/sec respectively.

The initial performance was a driving voltage of 5 V, 11 cd/A, and CIEx, y = (0.15, 0.26). The current linkage was 5x10⁻⁹ A/cm². The half-life was 2000 hr.

### Example 5

An organic EL device was fabricated in the same way as in Example 3 except that a glass substrate was used instead of the glass substrate having electrodes, metal Al was deposited to form a 100 nm thick film at a deposition rate of 0.8 nm/sec before the deposition of Alq and Li, and Cs and MoOₓ (x is 2 to 3) were co-deposited to form a cathode in a thickness of 1 nm at a deposition rate of 0.01 nm/sec and 0.1 nm/sec respectively.

The initial performance was a driving voltage of 4.5 V, 11 cd/A, and CIEx,y= (0.16, 0.26). The current linkage was 3x10⁻⁹ A/cm². The half-life was 2000 hr.

**Table 2**

| | @1mA/cm² | | | Lifetime at initial luminance of 3000 nit | Current linkage (A/cm²) |
|---|---|---|---|---|---|
| | Voltage (V) | L/J (cd/A) | CIE (x,y) | Half life (h) | |
| Example 3 | 4.5 | 10 | 0.16, 0.26 | 2000 | 2×10⁻⁹ |
| Comparative example 2 | 7 | 6.0 | 0.16, 0.25 | 1000 | 1×10⁻⁶ |
| Example 4 | 5 | 11 | 0.15,0.26 | 2000 | 5×10⁻⁹ |
| Example 5 | 4.5 | 11 | 0.16,0.26 | 2000 | 3×10⁻⁹ |

### Industrial Applicability

The organic EL device of the invention can be applied to personal and industrial displays, specifically, a cellular phone, PDA, automobile navigation system, monitor, TV, etc.

## Claims

1. An organic electroluminescent device comprising:
at least a cathode, an emitting layer, a hole-injecting layer and an anode on a substrate in this order;
the hole-injecting layer comprising a metal oxide.

2. The organic electroluminescent device according to claim 1, wherein the hole-injecting layer has a thickness of 40 to 1000 nm.

3. The organic electroluminescent device according to claim 1, wherein the metal oxide is an oxide of a metal of the groups 3 to 13 in the long form periodic table.

4. The organic electroluminescent device according to claim 1, wherein the metal oxide is one, or two or more metal oxides selected from a molybdenum oxide, vanadium oxide, hafnium oxide, yttrium oxide, zinc oxide and aluminum oxide.

5. The organic electroluminescent device according to claim 1, wherein the hole-injecting layer comprises 0.01 to 50 atm% of the metal oxide.

6. The organic electroluminescent device according to claim 1, wherein a protecting layer is provided between the hole-injecting layer and the anode.

7. The organic electroluminescent device according to claim 6, the protecting layer comprises a metal.

8. The organic electroluminescent device according to claim 7, wherein the protecting layer comprises Ag, Au or an alloy thereof.

9. The organic electroluminescent device according to claim 6, wherein the protecting layer comprises a semiconductor.

10. The organic electroluminescent device according to claim 6, wherein the protecting layer comprises an insulator.

11. The organic electroluminescent device according to claim 1, wherein an insulative layer is provided between the cathode and the emitting layer.

12. The organic electroluminescent device according to claim 1 or 11, wherein an electron-transporting layer is provided between the cathode and the emitting layer, or the insulative layer and the emitting layer.

13. An organic electroluminescent device comprising:
at least a cathode, an emitting layer, a metal oxide layer and an anode on a substrate in this order.

14. The organic electroluminescent device according to claim 13, wherein the metal oxide layer comprises at least one metal oxide selected from a molybdenum oxide, vanadium oxide, rhenium oxide, ruthenium oxide, tungsten oxide, zinc oxide, titanium oxide and copper oxide.

15. The organic electroluminescent device according to claim 13, wherein the anode comprises a conductive film and a protecting film in this order from the substrate.

16. The organic electroluminescent device according to claim 15, wherein the protecting film comprises an oxide, a nitride or an oxynitride of at least one element selected from Si, Ge, Mg, Ta, Ti, Zn, Sn, In, Pb and Bi.

17. The organic electroluminescent device according to claim 15, wherein the protecting film comprises an oxide, a nitride or an oxynitride of at least one element selected from the group consisting of Mo, V, Cr, W, Ni, Co, Mn, Ir, Pt, Pd, Ce, Pr, Nd, Sm, Eu, Gd, Tb, Dy, Er and Yb.

18. The organic electroluminescent device according to claim 15, wherein the protecting film transmits light.

19. The organic electroluminescent device according to claim 15, wherein a metal layer is provided between the conductive film and the protecting film.

20. The organic electroluminescent device according to claim 15, wherein a metal layer is provided between the metal oxide layer and the anode, or the emitting layer and the metal oxide layer.

21. The organic electroluminescent device according to claim 19 or 20, wherein the metal layer comprises an alloy containing at least one metal selected from Mg, Ag and Zr.

22. The organic electroluminescent device according to claim 13, wherein the cathode comprises at least one metal selected from alkali metals and alkaline earth metal, and a metal oxide.

23. The organic electroluminescent device according to claim 22, wherein the metal oxide contained in the cathode is at least one metal oxide selected from LiₓTi₂O₄, LiₓV₂O₄, ErₓNbO₃, LaₓTiO₃, SrₓVO₃, CaₓCrO₃ and SrₓCrO₃ (X is 0.2 to 5).

24. The organic electroluminescent device according to claim 22, wherein the metal oxide contained in the cathode is at least one metal oxide selected from AₓMoO₃ (A is K, Cs, Rb, Sr, Na, Li or Ca) (x is 0.2 to 5) and AₓV₂O₅ (A is K, Cs, Rb, Sr, Na, Li or Ca) (x is 0.2 to 5).

25. The organic electroluminescent device according to claim 1 or 13, wherein the anode is a transparent electrode and the cathode is a reflecting electrode.

26. A display comprising the organic electroluminescent device according to claim 1 or 13.
